# EUROPEAN PATENT SPECIFICATION

(11) **EP 0 939 470 B1**
(45) Date of publication and mention of the grant of the patent: **24.12.2008**
(21) Application number: 99301478.6
(22) Date of filing: 26.02.1999
(51) Int. Cl.: H01S 5/0683

(54) **Wavelength controlling circuit for laser signal**
Wellenlängesteuerungskreis für Lasersignalen
Circuit de contrôle de la longueur d'onde d'un signal laser

(30) Priority: 27.02.1998 JP 4780798
(43) Date of publication of application: 01.09.1999
(73) Proprietor: NEC CORPORATION, Tokyo (JP)
(72) Inventor: Yasuda, Norihiro, Minato-ku, Tokyo (JP)
(74) Representative: W.P. Thompson & Co.

(56) References cited:
- EP-A- 0 818 857
- PATENT ABSTRACTS OF JAPAN vol. 012, no. 403 (E-674), 26 October 1988 (1988-10-26) -& JP 63 143888 A (YOKOGAWA ELECTRIC CORP), 16 June 1988 (1988-06-16)
- PATENT ABSTRACTS OF JAPAN vol. 1996, no. 05, 31 May 1996 (1996-05-31) -& JP 08 018145 A (OLYMPUS OPTICAL CO LTD), 19 January 1996 (1996-01-19)

## Description

This invention relates to a circuit for controlling the wavelength of laser light. In a particular arrangement to be described below, by way of example in illustration of the invention, a wavelength controlling circuit for a laser signal has the function of providing a rough adjustment of the oscillation wavelength of laser light.

Investigations into methods of wavelength multiplexing in an optical transmission system are being actively carried out at present, and there is an increased demand for a technique for transmitting signals of many wavelengths. However, the wavelength band of a signal which can be used by an optical amplifier is restricted, and in order to allow the restricted wavelength band to have as great a number of channels as possible, it is necessary to narrow the wavelength interval and to stabilize the oscillation frequency of a laser signal with a high degree of accuracy.

A previously proposed method of stabilizing the oscillation frequency of a laser signal of an optical transmitter included controlling the temperature of a laser module.

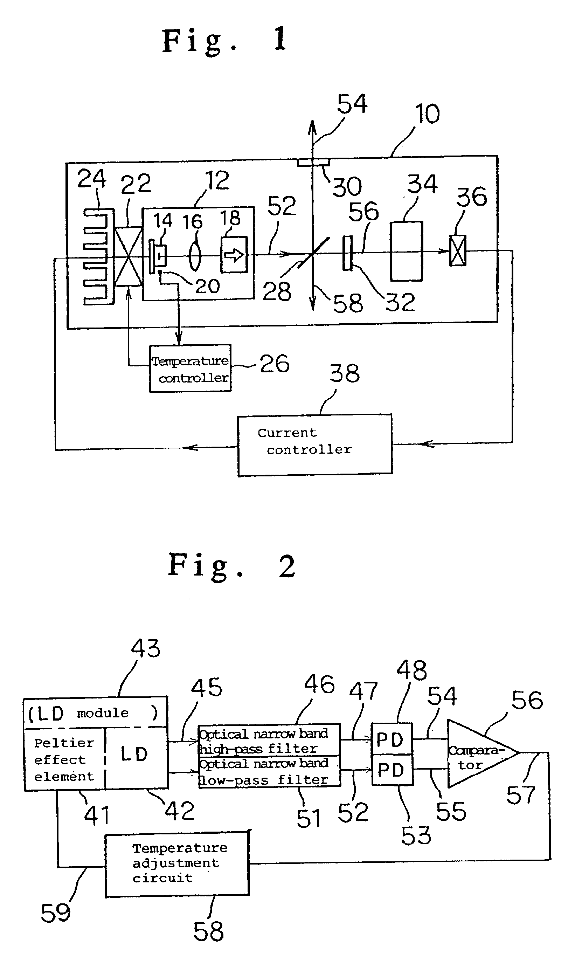

A block schematic diagram shown in Fig. 1 of the accompanying drawings illustrates an arrangement which has been previously proposed in the specification of Japanese Patent Laid-Open No. 302948/1995. A wavelength stabilization apparatus disclosed in Fig. 1 includes a temperature sensor 20 and a Peltier element 22 arranged in proximity to a semiconductor laser 14, and a temperature controller 26 which drives the Peltier element 22 in response to an output of the temperature sensor 20. Further, there is included a polarizing beam splitter 28, a 1/4 wavelength plate 32, an etalon 34 and a photodiode 36, in order, in front of a light source unit 12, and a current controller 38 which supplies input current to the semiconductor laser 14 in response to an output from the photodiode 36 to stabilize the wavelength of the light to be emitted.

Referring now to Fig. 2 of the accompanying drawings, there is shown a block schematic diagram which illustrates a laser wavelength controlling apparatus based on that disclosed in the specification of Japanese Patent Laid-Open No. 37334/1996. In Fig. 2, there is shown a laser diode 42 and a Peltier effect element 41, which controls the temperature of the laser diode 42, arranged in an LD module 43. Laser light 45 generated by the LD module 43 is introduced into an optical narrow band high-pass filter 46 and optical narrow band low-pass filter 51, and the transmission of light through them is detected by photodiodes 48, 53, respectively. Filters 46, and 51 transmit light components at wavelengths displaced a little by an equal wavelength to the longer wavelength side and the shorter wavelength side from a desired oscillation centre wavelength of the laser light. Accordingly, if the Peltier effect element 41 is controlled by a temperature adjustment circuit 58 so that the light components detected by the photodiodes 48, 53 may be equal to each other, the laser light can be set to the desired oscillation centre frequency.

However, the first mentioned previously proposed former wavelength stabilization apparatus has a problem in that, even if the temperature is controlled at a fixed value, the wavelength suffers from drift resulting from the secular degradation of the semiconductor laser or the temperature sensor.

Furthermore, with the second mentioned previously proposed laser wavelength controlling apparatus, although it provides an improvement in countering the drift of the wavelength as a result of the secular degradation of the laser diode or the temperature sensor, it is not easy to set to an intended wavelength.

Features of a wavelength controlling circuit for a laser signal to be described below, by way of example in illustration of the invention are that it enables a laser signal to be set to a target wavelength more readily upon the wavelength control of the laser signal and that it minimises the problem of drift.

Patent Abstracts of Japan vol 012, no. 403 (E-674) 26 October 1988 and JP 63 143888A discloses a wavelength controlling circuit including a laser diode a temperature detection element and a temperature adjustment element, a wavelength controlling means having an optical band-pass filter used as a wavelength discrimination element for controlling the wavelength of the laser wavelength and a temperature controlling means suitable for adjusting the wavelength of the laser roughly so that the wavelength may be included in the discrimination allowing range of the filter. Similar arrangements are also known from Patent Abstracts of Japan vol. 1996, no. 05 31 May 1996 and JP 08 018145; and EP-A-0 818 857.

In a particular wavelength controlling circuit for a laser signal to be described below, by way of example, there is a laser diode module including a semiconductor laser diode, a temperature detection element and a temperature adjustment element, wavelength controlling means including an optical band-pass filter used as a wavelength discrimination element for controlling the wavelength of a laser signal within a range of fine adjustment within which the wavelength can be discriminated by the optical band-pass filter, and temperature controlling means for adjusting roughly, when the wavelength of the laser signal is outside the range within which the wavelength can be discriminated with a wavelength discrimination characteristic by the optical band-pass filter, the wavelength of the laser signal so that the wavelength may be included in the range within which discrimination is allowed.

According to an aspect of the present invention, there is provided a wavelength controlling circuit for a laser signal which includes a laser diode having a semiconductor laser diode, a temperature detection element, a temperature adjustment element, monitoring means having an element which branches part of a laser signal output from the semiconductor laser diode, a wavelength discrimination element for monitoring the wavelength of the laser signal, and first adjustment means for generating a signal for finely adjusting the wavelength of the laser signal in response to an output from the monitoring means, a second adjustment means for generating a signal for roughly adjusting the wavelength of the laser signal in response to the result of the monitoring of the temperature which is monitored by the temperature detection element of the laser diode module, switching means for discriminating, in response to the result of the temperature monitoring of the laser diode module, that a predetermined wavelength is reached and for performing switching from the second adjustment means to the first adjustment means, and driving means for driving the temperature adjustment element of the laser diode module with the adjustment signals of the first and second adjustment means; and characterised in that: the switching means has a hysteresis in switching characteristic.

In yet another wavelength controlling circuit for a laser signal to be described below by way of example, there is a laser diode including a semiconductor laser diode, a temperature detection element and a temperature adjustment element, an element for branching a part of a laser signal output from the semiconductor laser diode, a wavelength monitoring circuit including a beam splitter for splitting the branched laser signal into two laser signals, an optical band-pass filter having a different optical wavelength transmission factor for receiving one of the split laser signals, a first optical detector for receiving the laser signal transmitted through the optical band-pass filter, and a second optical detector for receiving the other of the split laser signals, the wavelength monitoring circuit monitoring a range within which the wavelength of the laser signal can be discriminated by the optical band-pass filter, a first controlling circuit for generating a signal for finely adjusting the wavelength of the laser signal, the first controlling circuit including a divider for dividing an output from the second optical detector of the wavelength monitoring circuit by an output from the first optical detector, and a first amplifier for amplifying a difference voltage between an output signal from the divider and a first reference voltage, a second controlling circuit for generating a signal for roughly adjusting the wavelength of the laser signal so that the wavelength of the laser signal may come within a discrimination allowing range, the second controlling circuit including a temperature monitoring circuit connected to a thermistor of a laser diode module for detecting a voltage signal proportional to the temperature after an operation has started and a second amplifier for amplifying a difference between an output from the temperature monitoring circuit and a second reference voltage, a switching circuit for performing switching from the second controlling circuit, which roughly adjusts the wavelength of the laser signal, to the first controlling circuit, which finely adjusts the wavelength of the laser signal, the switching circuit including a comparison circuit for receiving the voltage proportional to the temperature by the rough adjustment of the wavelength of the laser signal and for generating an activation signal with a predetermined voltage and a switch which operates in response to the activation signal of the comparison circuit, and a driving circuit for driving the temperature adjustment element of the laser diode module with the fine adjustment signal of the first controlling circuit.

With the arrangements to be described, wavelength drift resulting from the secular degradation of a semiconductor laser, or from the secular change of a thermistor, is minimised as a result of the method of directly detecting and feeding back the wavelength of a laser signal, and the use of a wavelength monitor module which makes use of a transmission characteristic of an optical filter.

Further, with the arrangements to be described, whatever the ambient temperature or the like may be at the start of the control, the wavelength can be set initially to a value within a control allowing range and wavelength control may be achieved with a high degree of reliability while minimising the likelihood of a malfunction. The use of two controlling circuits; a wavelength controlling circuit and a temperature controlling circuit, together with an optical band-pass filter as a wavelength discrimination, contribute to this achievement.

Accordingly, for the reasons described above, it is possible, with these arrangements, to achieve the effect that the full width can be narrowed at half minimum of the optical band-pass filter; as well as a high degree of accuracy of the wavelength control.

The following description and drawings disclose, by means of an example, the invention which is characterised in the appended claims, whose terms determine the extent of the protection conferred hereby.

In the drawings:-
Fig. 3 is a block schematic diagram showing a wavelength controlling circuit for a laser signal,
Fig. 4 is a graph illustrating an output characteristic of a divider in the wavelength controlling circuit for a laser signal of Fig. 3,
Fig. 5 is a graph illustrating the switching control of an analog switch in the wavelength controlling circuit for a laser signal of Fig. 3, and
Fig. 6 is a graph illustrating the operation off the wavelength controlling circuit for a laser signal of Fig. 3.

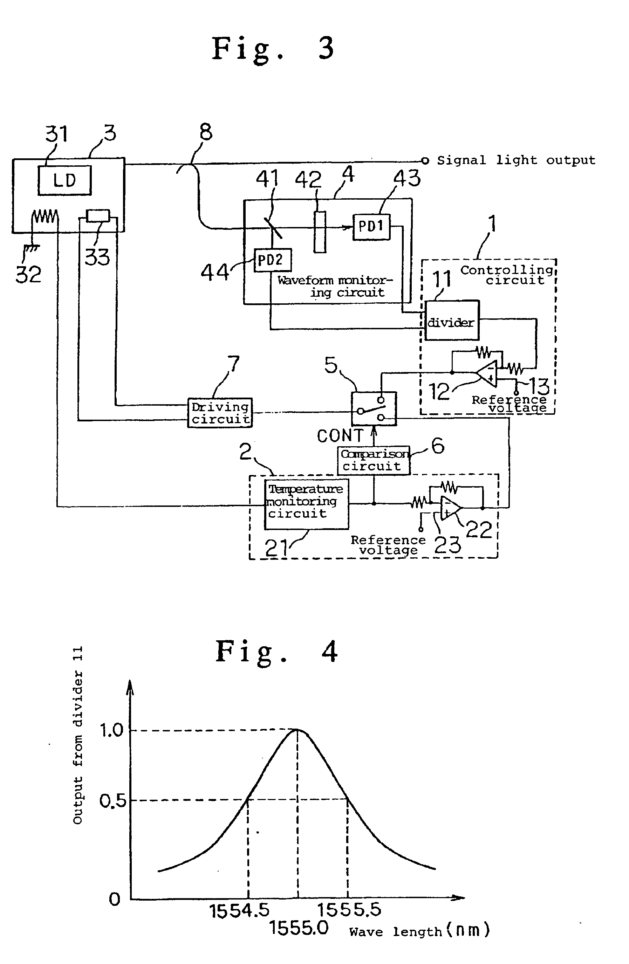

Referring to Fig. 3, there is shown an output beam from a laser diode module 3 branched into two beams by a light branching coupler 8, one of the two beams being generated as a laser signal and the other beam being applied to a waveform monitoring circuit 4. In the waveform monitoring circuit 4, the applied laser signal beam is branched into two beams by a beam splitter 41, and one of the beams is received by an optical detector 44, while the other beam is received by an optical detector 43 through an optical band-pass filter 42, which exhibits a different transmission factor for a different wavelength of light. An output from the optical detector 43 and an output from the optical detector 44 are applied to a divider 11 provided in a controlling circuit 1, and the divider 11 divides the output from the optical detector 43 by the output from the optical detector 44 to provide a division value. An output signal from the divider 11 is applied to an amplifier 12, by which a difference voltage between it and a reference voltage 13 is amplified, and the amplified difference voltage is generated as an output signal from the controlling circuit 1. The laser diode module 3 includes a semiconductor laser 31, a thermistor 32 having a resistance value, which varies depending upon the temperature, and a Peltier element 33, which heats/cools depending upon the direction of current therethrough. One of two terminals of the thermistor 32 is grounded, while the other terminal is connected to a temperature monitoring circuit 21 provided in the controlling circuit 2, so that a voltage signal proportional to the temperature is detected by the temperature monitoring circuit 21. An output from the temperature monitoring circuit 21 is applied to an amplifier 22 and a comparison circuit 6. The amplifier 22 amplifies a difference between the output from the temperature monitoring circuit 21 and the reference voltage 23 and generates an amplified difference as an output signal from the controlling circuit 2. Output signals from the controlling circuit 1 and the controlling circuit 2 are applied to an analog switch 5. As a control signal for the analog switch 5, an output from a comparison circuit 6 is connected to the analog switch 5, and in response to an output voltage signal from the temperature monitoring circuit 21, that is, the temperature of the laser diode module 3, one of the controlling circuit 1 and the controlling circuit 2 is selected by the analog switch 5 and its output is applied to a driving circuit 7. In response to the voltage signal from the controlling circuit 1, or the controlling circuit 2, the driving circuit 7 supplies current to the Peltier element 33 in the laser diode module 3 to heat or cool the laser diode module 3.

In the particular arrangement being described, a laser diode MQW-DFB-LD having a wavelength of 1.55 µm is used for the laser diode module 3, and a fusion type fiber coupler having a branching ratio of 10:1 is used for the light branching coupler 8. Further, in the waveform monitoring circuit 4, a beam splitter having a branching ratio of 1:1 is used for the beam splitter 41, a dielectric multilayer interference filter having a transmission center wavelength of 1,555 nm and having a full width at half maximum of 1 nm is used for the optical band-pass filter 42, and an indium-gallium-arsenide (InGaAs) photodiode having a binding quantum coefficient of 70 % is used for each of the optical detectors 43, 44.

Next, the operation of a wavelength controlling circuit for a laser signal will be described. First, the principle of wavelength control will be described. Fig. 4 illustrates the result of the measurement of a wavelength discrimination characteristic of the waveform monitoring circuit 4 of Fig. 3. The graph represents a division value (1 v corresponds to the ratio 1) when an output from the optical detector 43 is divided by an output from the optical detector 44 for a wavelength of a laser signal of laser diode module 3, and indicates that a wavelength discrimination characteristic, which does not rely upon the applied power, is obtained. Since generally the oscillation wavelength of a semiconductor laser has a temperature dependency of approximately 0.1 nm/°C, the oscillation wavelength can be controlled if the wavelength discrimination curve of Fig. 4 is used to control the temperature of the laser so that the division value may be fixed. For example, if the slope of the wavelength discrimination curve on the longer wavelength side is set so that the division value may be 0.5 v, that is, the reference voltage 13 of amplifier 12 is set to 0.5 v, then the wavelength is controlled to 1,555.5 nm.

The wavelength discrimination characteristic exhibits a higher detection sensitivity with respect to the variation of the wavelength as the full width at half maximum of the optical band-pass filter 42 decreases. However, as the full width at half maximum decreases, the range within which the wavelength can be monitored decreases. If it is intended to use the wavelength discrimination characteristic for control, when control is to be started, the wavelength of the laser diode module 3 must be initially set to a value in the proximity of the slope of the wavelength discrimination curve which is used for the control.

The arrangement being described is characterized in that the initial setting of the wavelength of a laser diode to a value in the proximity of the slope of the wavelength discrimination curve used for wavelength control is realized. The operation of the initial setting of the wavelength is described on the premise that, in the present arrangement, the slope of the wavelength discrimination curve of Fig. 4 on the longer wavelength side is used to control the wavelength to 1,555.5 nm as described above.

The wavelength of the laser diode module 3 when the power supply to the present circuit is made available may possibly be on the shorter wavelength side or on the longer wavelength side of the slope of the wavelength discrimination curve of Fig. 4 depending upon the ambient temperature. If the wavelength of the laser diode module 3 is on the shorter wavelength side of the slope, it is necessary initially to set the wavelength of the laser diode module 3 to the longer wavelength side of the slope. A detailed procedure therefor will be described below.

The oscillation frequency of the semiconductor laser has a temperature dependency of approximately 0.1 nm/°C as described above, and the temperature and the oscillation frequency of the laser diode chip have a substantially proportional relationship to each other. Therefore, by monitoring the temperature of the laser diode module 3, an approximate oscillation frequency of the laser diode module 3 can be deduced from the temperature. In particular, when the power supply to the present circuit is made available, the temperature of the laser diode module 3 is detected by the temperature monitoring circuit 21 and it is determined from the temperature whether the oscillation frequency is on the shorter wavelength side or the longer wavelength slope of the discrimination curve of Fig. 4, and if the oscillation frequency is on the shorter wavelength side, then the controlling circuit 2 is selected so that temperature control by the temperature monitoring circuit 21 is performed. Here, the reference voltage 23 is set to a value which corresponds to a sufficiently longer wavelength than the longer wavelength side slope of the wavelength discrimination curve of Fig. 4. Consequently, current flows through the Peltier element 33 in a heating direction, and the temperature of laser diode module 3 rises and the wavelength of the laser diode module 3 is displaced to the longer wavelength side of the slope. Thereafter, the selection is switched from the controlling circuit 2 to the controlling circuit 1 so that control according to the wavelength discrimination characteristic of the optical band-pass filter is performed to lock the oscillation frequency to 1,555.5 nm.

If the wavelength of the laser diode module 3 is on the longer wavelength side of the slope, the controlling circuit 1 is selected so that the oscillation frequency is locked to 1,555.5 nm by the control according to which wavelength discrimination characteristic is used. The switching between the controlling circuits 1, 2 is performed by the analog switch 5.

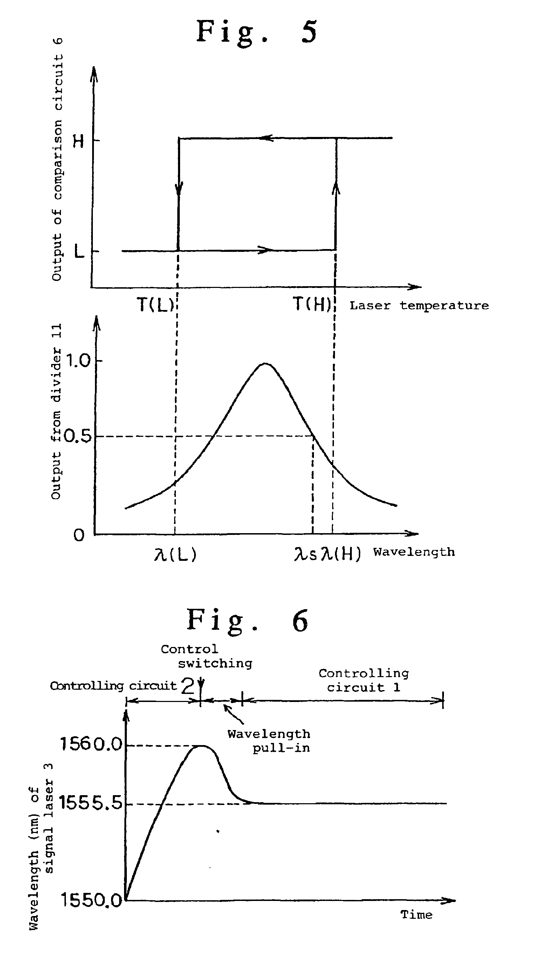

Next, a switching operation of the analog switch 5 will be described. The switching control of the analog switch 5 is performed by the comparison circuit 6. The comparison circuit 6 receives a voltage proportional to the result of monitoring by the temperature monitoring circuit 21 and generates an activation signal with a predetermined threshold voltage to switch the analog switch 5. The comparison circuit 6 is a function generator of a variable threshold voltage having a hysteresis characteristic. The threshold value of the comparison circuit 6 has a hysteresis width. The hysteresis width is set such that, as seen in Fig. 5, a temperature T(H) of the laser at which switching from the controlling circuit 2 to the controlling circuit 1 should be performed is set to the longer wavelength side with respect to a temperature corresponding to a wavelength to be locked, and the laser temperature T(L) at which switching from the controlling circuit 1 to the controlling circuit 2 should be performed is set to the shorter wavelength side with respect to a center wavelength of the discrimination curve. Consequently, after the output from the comparison circuit 6 changes over to "High" once, before the output from the comparison circuit 6 changes over to "tow", the oscillation frequency of the laser diode module 3 is locked by the controlling circuit 1.

A detailed procedure for the operation in which, when a power supply is made available, the wavelength of the laser diode module 3 is on the shorter wavelength side of the slope is illustrated in Fig. 6. After the power supply has been made available, since the analog switch 5 is connected to the controlling circuit 2 side and a current flows through the Peltier element 33 in a heating direction, the wavelength of laser diode module 3 is pulled up to the longer wavelength side. After the wavelength of laser diode module 3 has been pulled up to 1,560.0 nm, the output from the comparison circuit 6 changes over to "High", and the analog switch 5 is switched to the controlling circuit 1 side. The wavelength of the laser diode module 3 is pulled in to the locking wavelength side by the wavelength discrimination characteristic of the controlling circuit 1 and is locked to the wavelength of 1,555.5 nm.

It will be understood that, although a particular arrangement has been described by way of example in illustration of the invention, variations and modifications thereof, as well as other arrangements may be conceived within the scope of the appended claims.

## Claims

1. A wavelength controlling circuit for a laser signal which includes a laser diode having a semiconductor laser diode (31), a temperature detection element (32), a temperature adjustment element (33), monitoring means (4) having an element (8) which branches part of a laser signal output from the semiconductor laser diode (31), a wavelength discrimination element (42) for monitoring the wavelength of the laser signal, and first adjustment means (1) for generating a signal for finely adjusting the wavelength of the laser signal in response to an output from the monitoring means (4), a second adjustment means (2) for generating a signal for roughly adjusting the wavelength of the laser signal in response to the result of the monitoring of the temperature which is monitored by the temperature detection element (32) of the laser diode module, switching means (5) for discriminating, in response to the result of the temperature monitoring of the laser diode module, that a predetermined wavelength is reached, and for performing switching from the second adjustment means to the first adjustment means, and driving means for driving the temperature adjustment element (33) of the laser diode module with the adjustment signals of the first and second adjustment means (1, 2); and **characterised in that**:
the switching means has a hysteresis in switching characteristic.

2. A wavelength controlling circuit for a laser signal as claimed in claim 1 in which the monitoring means (4) for monitoring the wavelength of the laser signal includes an element for branching a part of the laser signal output from the semiconductor laser diode, and a wavelength monitoring circuit having a beam splitter (41) for splitting the branched laser signal into two laser signals, an optical band-pass filter (42) having a particular transmission factor of an optical wavelength for receiving one of the split laser signals, a first optical detector (43) for receiving the laser signal after transmission through the optical band-pass filter (42), and a second optical detector (44) for receiving the other of the split laser signals.

3. A wavelength controlling circuit for a laser signal as claimed in claim 2, in which the first adjustment means (1) for generating a signal for finely adjusting the wavelength of the laser signal in response to an output from the monitoring means is a first controlling circuit having a divider for dividing an output from the first optical detector (43) by an output from the second optical detector (44), and a first amplifier (12) for amplifying a difference voltage between an output signal from the divider and a first reference voltage.

4. A wavelength controlling circuit for a laser signal as claimed in claim 1, in which the second adjustment means (2) for generating a signal for roughly adjusting the wavelength of the laser signal in response to a result of the monitoring is a second controlling circuit having a temperature monitoring circuit connected to a thermistor of the laser diode module for detecting a voltage signal proportional to the temperature, and a second amplifier (22) for amplifying a difference between an output voltage from the temperature monitoring circuit and a second reference voltage.

5. A wavelength controlling circuit for a laser signal as claimed in claim 1, in which the switching means (5) for performing switching from the second adjustment means (2) to the first adjustment means (1) is a switching circuit having a comparison circuit (6) for receiving a voltage proportional to the result of monitoring the temperature and generating an activation signal with a predetermined voltage, and a switch which operates in response to the activation signal of the comparison circuit (6).

6. A wavelength controlling circuit for a laser signal as claimed in claim 5, in which the comparison circuit is a function generator of a variable rising input voltage having said hysteresis characteristic.

## Patentansprüche

1. Wellenlängenregelschaltung für ein Lasersignal, die Folgendes umfasst: eine Laserdiode mit einer Halbleiterlaserdiode (31), einem Temperaturerfassungselement (32) und einem Temperatureinstellelement (33), ein Überwachungsmittel (4) mit einem Element (8), das einen Teil eines Lasersignalausgangs von der Halbleiterlaserdiode (31) abzweigt, ein Wellenlängenunterscheidungselement (42) zum Überwachen der Wellenlänge des Lasersignals, und ein erstes Einstellmittel (1) zum Erzeugen eines Signals zum Feineinstellen der Wellenlänge des Lasersignals als Reaktion auf einen Ausgang vom Überwachungsmittel (4), ein zweites Einstellmittel (2) zum Erzeugen eines Signals zum Grobeinstellen der Wellenlänge des Lasersignals als Reaktion auf das Ergebnis der Überwachung der Temperatur, die vom Temperaturerfassungselement (32) des Laserdiodenmoduls überwacht wird, ein Schaltmittel (5), um als Reaktion auf das Ergebnis der Temperaturüberwachung des Laserdiodenmoduls zu unterscheiden, dass eine vorbestimmte Wellenlänge erreicht ist, und zum Ausführen des Umschaltens von dem zweiten Einstellmittel auf das erste Einstellmittel, und ein Ansteuermittel zum Ansteuern des Temperatureinstellelementes (33) des Laserdiodenmoduls mit den Einstellsignalen des ersten und des zweiten Einstellmittels (1, 2); und **dadurch gekennzeichnet, dass**:
das Schaltmittel eine Umschaltkennwerthysterese hat.

2. Wellenlängenregelschaltung für ein Lasersignal nach Anspruch 1, wobei das Überwachungsmittel (4) zum Überwachen der Wellenlänge des Lasersignals Folgendes beinhaltet: ein Element zum Abzweigen eines Teils des Lasersignalausgangs von der Halbleiterlaserdiode und eine Wellenlängenüberwachungsschaltung mit einem Strahlenteiler (41) zum Aufspalten des abgezweigten Lasersignals in zwei Lasersignale, ein optisches Bandpassfilter (42) mit einem bestimmten Transmissionsfaktor einer optischen Wellenlänge zum Empfangen eines der gespaltenen Lasersignale, einen ersten optischen Detektor (43) zum Empfangen des Lasersignals nach der Transmission durch das optische Bandpassfilter (42) und einen zweiten optischen Detektor (44) zum Empfangen des anderen der gespaltenen Lasersignale.

3. Wellenlängenregelschaltung für ein Lasersignal nach Anspruch 2, wobei das erste Einstellmittel (1) zum Erzeugen eines Signals zum Feineinstellen der Wellenlänge des Lasersignals als Reaktion auf einen Ausgang von dem Überwachungsmittel eine erste Regelschaltung mit einem Divisionsglied zum Dividieren eines Ausgangs von dem ersten optischen Detektor (43) durch einen Ausgang von dem zweiten optischen Detektor (44) und ein erster Verstärker (12) zum Verstärken einer Differenzspannung zwischen einem Ausgangssignal von der Divisionsschaltung und einer ersten Referenzspannung ist.

4. Wellenlängenregelschaltung für ein Lasersignal nach Anspruch 1, wobei das zweite Einstellmittel (2) zum Erzeugen eines Signals zum Grobeinstellen der Wellenlänge des Lasersignals als Reaktion auf ein Ergebnis der Überwachung eine zweite Regelschaltung mit einer Temperaturüberwachungsschaltung, die mit einem Thermistor des Laserdiodenmoduls verbunden ist, um ein Spannungssignal proportional zur Temperatur zu erfassen, und ein zweiter Verstärker (22) zum Verstärken einer Differenz zwischen einer Ausgangsspannung von der Temperaturüberwachungsschaltung und einer zweiten Referenzspannung ist.

5. Wellenlängenregelschaltung für ein Lasersignal nach Anspruch 1, wobei das Schaltmittel (5) zum Ausführen des Umschaltens von dem zweiten Einstellmittel (2) auf das erste Einstellmittel (1) eine Umschalt-Schaltung mit einer Vergleichsschaltung (6) zum Empfangen einer Spannung proportional zu dem Ergebnis der Überwachung der Temperatur und zum Erzeugen eines Aktivierungssignals mit einer vorbestimmten Spannung und einem Schalter ist, der als Reaktion auf das Aktivierungssignal der Vergleichsschaltung (6) arbeitet.

6. Wellenlängenregelschaltung für ein Lasersignal nach Anspruch 5, wobei die Vergleichsschaltung ein Funktionsgenerator einer variablen ansteigenden Eingangsspanung mit der genannten Hysteresecharakteristik ist.

## Revendications

1. Circuit de commande de longueur d'onde d'un signal laser qui comporte une diode laser ayant une diode laser à semi-conducteur (31), un élément de détection de température (32), un élément de réglage de température (33), un moyen de contrôle (4) ayant un élément (8) qui fait bifurquer une partie de la sortie de signal laser de la diode laser à semi-conducteur (31), un élément de discrimination de longueur d'onde (42) pour contrôler la longueur d'onde du signal laser, et un premier moyen de réglage (1) pour générer un signal servant à régler finement la longueur d'onde du signal laser en réponse à une sortie du moyen de contrôle (4), un second moyen de réglage (2) pour générer un signal servant à régler grossièrement la longueur d'onde du signal laser en réponse au résultat du contrôle de la température qui est contrôlée par l'élément de détection de température (32) du module de diode laser, un moyen de commutation (5) pour établir, en réponse au résultat du contrôle de température du module de diode laser, qu'une longueur d'onde prédéterminée est atteinte, et pour effectuer une commutation du second moyen de réglage au premier moyen de réglage, et un moyen d'attaque pour attaquer l'élément de réglage de température (33) du module de diode laser avec les signaux de réglage des premier et second moyens de réglage (1, 2) ; et **caractérisé en ce que** :
le moyen de commutation a une caractéristique d'hystérésis en commutation.

2. Circuit de commande de longueur d'onde d'un signal laser selon la revendication 1, dans lequel le moyen de contrôle (4) pour contrôler la longueur d'onde du signal laser comporte un élément pour faire bifurquer une partie de la sortie de signal laser de la diode laser à semi-conducteur, et un circuit de contrôle de longueur d'onde ayant un diviseur de faisceau (41) pour diviser le signal laser bifurqué en deux signaux laser, un filtre passe-bande optique (42) ayant un facteur de transmission particulier d'une longueur d'onde optique pour recevoir l'un des signaux laser divisés, un premier détecteur optique (43) pour recevoir le signal laser après la transmission à travers le filtre passe-bande optique (42) et un second détecteur optique (44) pour recevoir l'autre des signaux laser divisés.

3. Circuit de commande de longueur d'onde d'un signal laser selon la revendication 2, dans lequel le premier moyen de réglage (1) pour générer un signal servant à régler finement la longueur d'onde du signal laser en réponse à une sortie du moyen de contrôle est un premier circuit de commande ayant un diviseur pour diviser une sortie du premier détecteur optique (43) par une sortie du second détecteur optique (44), et un premier amplificateur (12) pour amplifier une tension de différence entre un signal de sortie du diviseur et une première tension de référence.

4. Circuit de commande de longueur d'onde d'un signal laser selon la revendication 1, dans lequel le second moyen de réglage (2) pour générer un signal servant à régler grossièrement la longueur d'onde du signal laser en réponse à une sortie du moyen de contrôle est un second circuit de commande ayant un circuit de contrôle de température connecté à une thermistance du module de diode laser pour détecter un signal de tension proportionnel à la température, et un second amplificateur (22) pour amplifier une différence entre une tension de sortie du circuit de contrôle de température et une seconde tension de référence.

5. Circuit de commande de longueur d'onde d'un signal laser selon la revendication 1, dans lequel le moyen de commutation (5) pour effectuer une commutation du second moyen de réglage (2) au premier moyen de réglage (1) est un circuit de commutation ayant un circuit de comparaison (6) pour recevoir une tension proportionnelle au résultat du contrôle de température et générer un signal d'activation à une tension prédéterminée, et un commutateur qui fonctionne en réponse au signal d'activation du circuit de comparaison (6).

6. Circuit de commande de longueur d'onde d'un signal laser selon la revendication 5, dans lequel le circuit de comparaison est un générateur de fonction d'une tension d'entrée croissante variable ayant ladite caractéristique d'hystérésis.
